# EUROPEAN PATENT APPLICATION

(11) **EP 1 675 439 A2**
(43) Date of publication of application: **28.06.2006**
(21) Application number: 05077941.2
(22) Date of filing: 20.12.2005
(51) Int. Cl.: H05B 33/08

(54) **Lamp assembly for pulse operation**

(30) Priority: 21.12.2004 GB 0427880
(71) Applicant: Barton, Richard Peter James, Ulverston LA12 7NQ (GB)
(72) Inventor: Barton, Richard Peter James, Ulverston LA12 7NQ (GB)

(57) **Abstract**

One or more light-emitting diodes (LEDs) 1 are hard-wired to a connector 2 through a mechanical/electrical interface 3. The interface 3 provides mechanical support, electrical connection and thermal connection, and includes in particular a charge storage component such as a capacitor 4. The interface will in general also include additional circuit components 5 such as resistors or protection devices. In one implementation the connector is connected directly to the external wiring 6 without the need for any additional connectors. The invention reduces the peak current drawn by the LED to allow replacement of conventional combinations of filament lamp and lampholder for pulse operation. Such pulse operation may be used to address a large number of LEDs sequentially or by matrix addressing, and can also be used to control the light output from the LED by changing the pulse length.

## Description

### Technical Field

This invention relates to lamps, and in particular to the use of solid-state lamps to replace filament lamps in a wide range of applications where the filament bulb is conventionally driven with a pulsed power supply.

### Background Art

Small filament lamps are used in a wide range of applications, including entertainment machines, electronic equipment and vehicle equipment both as indicator lamps and for more general illumination. In a number of applications the lamp is driven using a pulsed power supply in order to allow a number of lamps to be addressed sequentially so as to allow the lamps to be matrix addressed as part of a larger display, to reduce the complexity and cost of the drive electronics, and to reduce the number of connections to the lamp array. At frequencies above the "critical fusion frequency", typically between 50 and 100Hz, a pulsed light source appears to the eye as a steady time-independent light source. For filament bulbs the long response time of the filament assists in producing this illusion. In a typical application the power supply could have a duty cycle of 1/16, with the power on for 1ms and off for 15ms, giving a repetition frequency of about 63Hz, and hence giving illumination that appears constant to the eye. The eye averages the light output from the source, and so the light emitted by the source during the pulse must be greater than the required average light output by a factor equal to the duty cycle. In a filament bulb the light output is a highly non-linear function of current, so that to achieve the high light output during the pulse, the current during the pulse is only a small factor greater than the steady current needed to give the same average light output. For example, for a duty cycle of 1/1.6, ideally the current during the pulse is only twice the equivalent steady current.

Filament lamps are prone to failure after relatively short periods of operation. Such failures not only require time and resources to replace the lamps, but also mean that there are periods when the indication or illumination functions are not operational. In entertainment machines, for example, this will involve loss of revenue. For this reason, and for reasons of energy efficiency, filament lamps are being replaced in many applications by solid-state lamps, usually light-emitting diodes (LEDs). As usually supplied, these LEDs cannot be used as direct replacements for filament lamps because the connections are not the same and because the voltages needed to drive an LED and a filament lamp are different. However, direct replacement LEDs are now available commercially in which the LED is permanently attached in an assembly that provides contacts directly compatible with a lampholder designed for a filament lamp. In addition, resistors and protection devices can be included within the assembly to ensure that the LED can be driven from the same voltage source that is used for the filament bulb.

These replacement LEDs are commercially successful because they are much more reliable, and also much more efficient, providing the same light output for a lower current and lower power dissipation. The use of LEDs in this way therefore reduces the cost of ownership of the system or machine in which they are installed because of reduced power requirements, reduced replacement costs, and because there is no loss of revenue or function as a result of failure.

For pulsed operation, however, replacement of filament bulbs by LEDs is not straightforward. For LEDs the response is almost linear. If a filament bulb is simply replaced by an LED the current is higher during the pulse, when the power supply is on, than the average current by a factor equal to the duty cycle. In order to give a light output equivalent to a typical average current of 30mA in the application described above the peak current would be almost 0.5A during the 1ms pulse. The reliability of LEDs is a strong function of the operating current, and so direct replacement of a filament bulb by an LED in this application would not give the expected reliability and cost-savings. It is also expected that subjecting the LED to high current pulses will lead to additional failure mechanisms.

Pulsed operation of LEDs has been used extensively in the past, and there are a number of patents relating to this mode of operation. Invariably, however, the prior patents and applications are concerned with new drive or control circuits intended to achieve improved performance or reduced cost. For example, patent US4673865 provides a method of generating a voltage sufficient to drive an LED from a low-voltage battery by using pulsed operation. US6400101 describes a drive circuit describes a drive circuit with a control loop containing a low-pass filter that allows an LED to be operated in pulse mode with a constant mean value of LED current. The invention described in this application is fundamentally different to previous inventions in that it describes the invention of a lamp assembly that is a direct replacement for a filament lamp in pulsed operation without requiring any modification to the power supplies used for filament lamps, thereby providing a cost-efficient and rapid means of replacement of filament bulbs by LEDs.

This invention overcomes the problem of using an LED with a pulsed power supply by incorporating a charge storage device or integrating component, most conveniently an electrical capacitor, within the lamp assembly. The lamp assembly is a direct replacement for a filament bulb. In the implementation where a capacitor is used, current flows into the capacitor during the drive pulse, increasing the total charge in the capacitor and hence the voltage that appears across the capacitor. This charge and hence the voltage is controlled by the values of the capacitor and resistors in the circuit, and also by the length of the drive pulse. When there is no drive pulse the capacitor discharges through one or more LEDs connected across the capacitor, at a rate determined by additional circuit components. With suitable choice of capacitor and resistor values the peak current through the LED is greatly reduced, increasing reliability to that expected for LEDs driven by a DC supply.

### Description

The object of the present invention is to allow a single LED lamp assembly to replace a filament lamp together with the lampholder or socket in pulsed applications. The complete LED lamp assembly comprises one or more LEDs connected in an electrical circuit that contains one or more capacitors and resistors. Additional circuit components such as protection diodes can be included in the circuit. Different implementations of the invention are possible, such as one where the circuit components are hard wired between the LEDs and an insulation displacement connector (IDC) or other similar connector, and the IDC is connected directly to the wiring of the system or machine without any intermediate connectors. The lamp assembly can be fabricated to allow direct attachment to the control panel, fascia board or other part of the entertainment machine or other system. In an alternative implementation the electrical components are hard wired within a lampholder that is connected to the system or machine, and one or more LEDs inserted in the lampholder.

One preferred **implementation** of the invention will now be described with reference to the attached figures
Figure 1 is a front plan view of the complete lamp assembly
Figure 2 is top plan view of the complete lamp assembly.
Figures 3a), b), and c) are circuit diagram of the lamp with circuitry that can be included in the assembly.

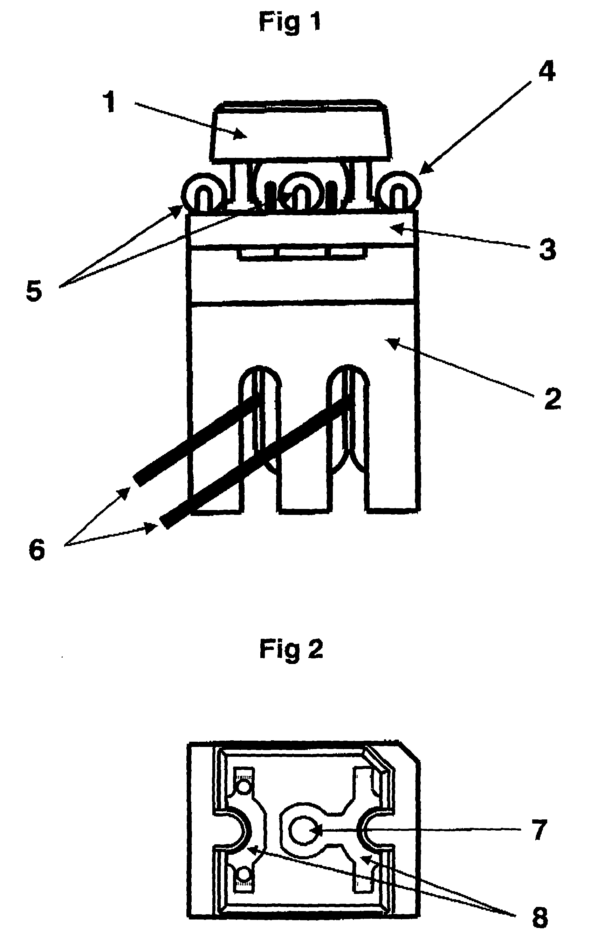

Referring to the drawings, figure 1 shows the LED lamp **1** mounted on the insulation displacement connector **2,** through a mechanical/electrical interface **3.** In this implementation the LED lamp **1** is shown as a four pin flat-top device, but any other LED structure is possible. The LED lamp **1** is soldered in this implementation to the capacitor **4** and also to resistors **5.** The components are shown soldered to an insulation displacement connector (IDC) 2 in this implementation. Other implementations are also possible in which the electrical contacts form part of the connector **2** which provide both mechanical support and electrical connection. The IDC **2** allows direct connection to the external circuit wires **6** without the need for soldering, giving a secure connection which can be made rapidly and easily. IDC connectors have proven reliability, and also provide a reproducible electrical and thermal connection.

The essential feature of the invention shown in figure 1, is that in this implementation the lamp assembly contains a capacitor **4** and resistors **5** between the one or more LEDs and the wires **6** connecting the lampholder to the machine, giving an assembly that can be driven directly in pulsed operation.

Figure 2 shows the top view of the assembly, where an LED chip 7 is mounted on the lead frame **8;** together comprising the lamp **1.** In this implementation the lead frame has four pins and the LED package is flat-topped. Other versions are also possible, including a conventional round-top LED and a two-pin lead frame.

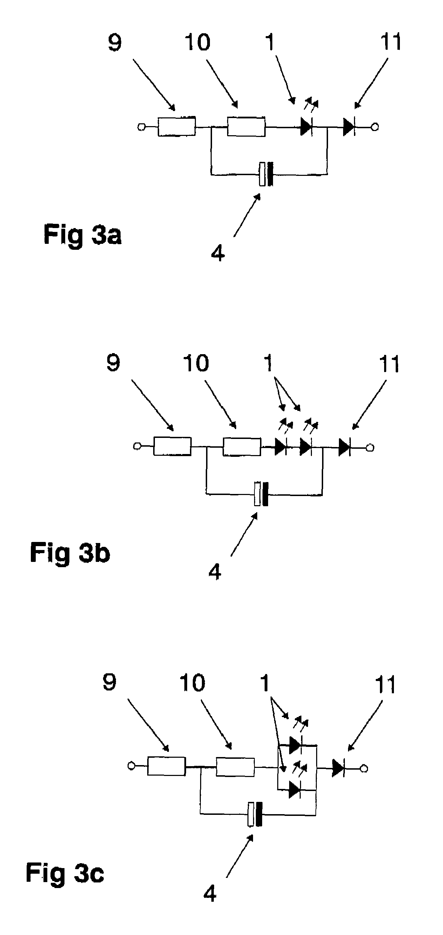

Additional electrical circuit components are included within the interface **3.** Possible circuits are shown in figure 3, allowing the lamp to be used under pulsed operating conditions, and also providing protection in cases where the wrong polarity of voltage is accidentally applied. Figure 3a) shows the circuit symbol for the LED lamp **1** together with the capacitor **4,** the charging resistor **9,** the discharging resistor **10** and a protection diode **11.** Figure 3b) shows two LEDs connected in series with the discharging resistor **10** across the capacitor **4,** and figure 3c) shows two LEDs connected in parallel. In figure 3b) the value of the discharging resistor 10 is less than the value of the resistor in figure 3a), leading to greater energy efficiency because less power is dissipated in the resistor 10.

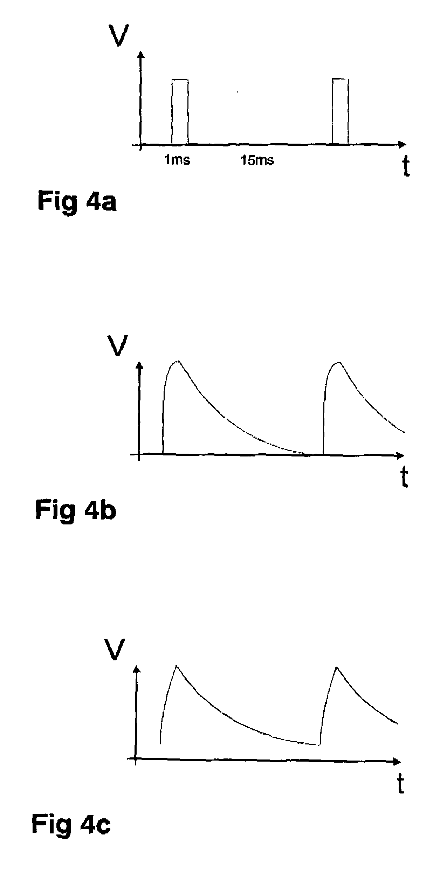

With reference to figure 3a) the rate at which the capacitor charges during the pulse is controlled primarily by the magnitude of the charging resistor **9** and the capacitor **4.** If these two components give rise to a charging time that is significantly less than the pulse length, the capacitor **4** will be fully charged to the supply voltage during the pulse. At the end of the pulse the capacitor will discharge through resistor **10** and the LED **1** at a rate determined by the capacitor **4** and the discharging resistor **10.** By adjusting the value of resistor **10** the current through the LED lamp 1 can be controlled to give the required light output. The voltage across the capacitor **4** in this operating regime is shown as a function of time in figure 4b), for the input voltage shown in figure 4a). The voltage shown in figure 4b) also appears across the series combination of the LED lamp **1** and the discharging resistor **10,** and determines the LED current and light output.

If the charging time is sufficiently large, corresponding to larger values of the resistor **9,** the voltage appearing across the capacitor at the end of the pulse will be a function of the length of the pulse. At the end of the pulse the current through the LED lamp **1** will therefore also be a function of pulse length, and so the length of the pulse can be used to control the light output from the LED. The voltage across the capacitor **4** is shown as a function of time in figure 4c) in this case of long charging times. The charging time is controlled by resistor **9** and the discharging time by resistor **10.**

It is understood that the embodiment described in figures 1, 2 and 3 is only one of a number of different embodiments, and is described by way of example only. Other LED lamps of different shape or number can also be used, different electrical components and devices can be included, and different sizes of IDC can also be used.

## Claims

1. A lamp assembly having a solid-state lamp or lamps **1** connected to a charge storage component or an integrating component **4** and control components **5** through a mechanical/electrical interface **3** suitable for connection to external circuit wiring **6** through a connector **2,** as a direct replacement for a filament bulb, in order to allow efficient pulse operation.

2. A lamp assembly in which the lamp is an LED.

3. A lamp assembly in which the connector is an insulation displacement connector.

4. A lamp assembly in which the charge storage component is a capacitor **4** and the control components are resistors **5.**

5. A lamp assembly in which the LED **1** and the components are soldered to the connector **2.**

6. A lamp assembly in which the LED **1** and the components arc connected via the interface **3** by means of crimping or other hard-wiring techniques.

7. A lamp assembly which contains more than one LED, connected either in parallel or in series, or a combination of the two.

8. A lamp assembly in which the circuit components are chosen so as to allow the light output from the LEDs to be controlled by varying the pulse length.

9. A lamp assembly according to claim 1 substantially as described with reference to and as illustrated in the attached drawings.
